# FASCICULE DE BREVET EUROPEEN

(11) **EP 0 421 839 B1**
(45) Date de publication et mention de la délivrance du brevet: **17.11.1994**
(21) Numéro de dépôt: 90402641.6
(22) Date de dépôt: 25.09.1990
(51) Int. Cl.: G11C 16/06, G11C 7/00

(54) **Mémoire à temps de lecture amélioré**
Speicher mit verbesserter Lesezeit
Memory with improved reading time

(30) Priorité: 02.10.1989 FR 8912845
(43) Date de publication de la demande: 10.04.1991
(73) Titulaire: SGS-THOMSON MICROELECTRONICS S.A., 94250 Gentilly (FR)
(72) Inventeur: Edme, Franck, 7, rue le Sueur, F-75116 Paris (FR)
(74) Mandataire: Schmit, Christian Norbert Marie

(56) Documents cités:
- EP-A- 0 049 462
- GB-A- 2 070 372
- PATENT ABSTRACTS OF JAPAN, vol. 5, no. 185 (P-091), 25 novembre 1981;& JP-A-56 114 193

## Description

La présente invention a pour objet une mémoire en circuit intégré dont le cycle de lecture est accéléré. Cette accélération est due à une pré-charge plus puissante et plus rapide des lignes de bits. L'invention trouve plus particulièrement son application dans le domaine des mémoires de type EPROM ou dans le domaine des mémoires de type EEPROM dans lesquels le point mémoire possède un transistor à grille flottante comme organe de mémorisation.

Les points mémoires d'une mémoire sont organisés d'une manière matricielle aux intersections de lignes et de colonnes : les lignes sont dites les lignes de bits les colonnes sont des lignes de mots. Pour accéder à l'information qui est contenue dans un point mémoire, on sélectionne au moyen de décodeurs une ligne de bits et une ligne de mots caractéristiques du point mémoire à lire. La sélection d'un point mémoire a pour objet de le relier à un circuit de détection en courant (dit SENSE dans la littérature anglo-saxonne). Le point mémoire constitué par le transistor à grille flottante se comporte alors, selon son état de programmation, comme un circuit ouvert ou comme une résistance. S'il est une résistance la ligne de bits auquel il appartient est, au moment de la sélection, reliée à la masse du circuit de la mémoire. Dans ces conditions un courant de décharge peut circuler sur la ligne de bits. Par contre, s'il est un circuit ouvert, la tension appliquée sur la ligne de bits se conserve et le détecteur de courant ne détecte pas le passage de courant de court circuit. En conséquence on a ainsi transformé un état électrique statique, l'état électrique programmé dans le point mémoire, en un état électrique dynamique : variant dans le temps. On utilise ensuite ce changement d'état dans les différents circuits reliés à la mémoire.

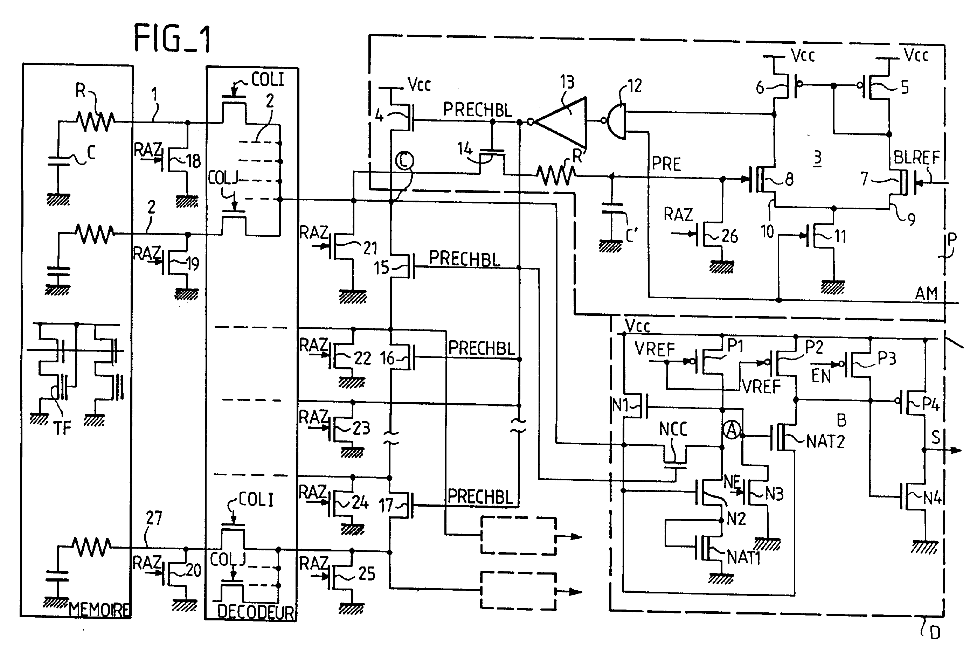

Tel qu'il vient d'être décrit, le processus nécessite la pré-charge de la ligne de bits à une certaine tension, avant la sélection du point mémoire concerné par la ligne de mots. Le détecteur de courant est relié à la ligne de bits au moins à la fin de cette pré-charge. Dès que la ligne de mots concernée est activée, le phénomène de court circuit ou de circuit ouvert se produit et du courant passe ou ne passe pas dans le détecteur de courant. Etant donné que le détecteur de courant est ainsi relié au préalable à la ligne de bits, il a été mis au point des procédés de pré-charge de la ligne de bits dans lesquels le circuit de pré-charge de la ligne de bits est intégré au détecteur de courant. Un circuit D de ce type est reconnaissable sur la figure 1. Cette figure concerne l'invention mais montre également l'état de la technique avec le détecteur de courant D. Avec un tel circuit, on arrive à pré-charger des lignes de bits, assimilables au moment de la pré-charge ou de la lecture à un circuit RC, au bout d'une durée sensiblement égale à 50 ns.

Le fonctionnement de ce circuit classique de pré-charge est le suivant : au départ, la ligne de bits représentée par un quelconque des circuits RC à gauche de la figure 1 est connectée au point C. Le potentiel de la ligne de bits est à V_{SS}, égal à zéro volts. Pour pré-charger la ligne de bits on active le détecteur D, par exemple au moyen d'un signal VREF qui est appliqué sur la grille d'un transistor P₁ de type p. Le transistor P₁ est relié d'une part à V_{cc} (tension d'alimentation) et d'autre part à un point A. La commande par VREF a pour objet de porter A à la valeur de V_{cc}. Ce faisant, un transistor N₁ de type n, qui est relié par son drain au potentiel Vcc et qui reçoit le potentiel du point A sur sa grille, devient conducteur. Il en est de même d'un transistor natif NAT₂ qui reçoit le potentiel du point A sur sa grille et dont le drain est également relié à Vcc par la mise en conduction d'un transistor P₂ de type p. Le transistor P₂ est commandé lui aussi par le potentiel de commande VREF. Les transistors N₁ et NAT₂ chargent alors la ligne de bits à laquelle ils sont reliés au point C par leur source. La tension du point C monte. Comme la tension du point C monte, on provoque la mise en conduction d'un transistor N₂ de type n. Le transistor N₂ est en cascade, entre le transistor P₁ et un transistor NAT₁ de type n, entre Vcc et la masse. Le transistor N₂ reçoit la tension du point C sur sa grille. Le transistor NAT₁ est monté en diode à cause de la connexion de sa grille à son drain.

Une contre réaction s'exerce alors sur la tension du point A. La tension du point A se stabilise donc à une tension intermédiaire déterminée par les transistors P₁, N₂ et NAT₁. Le transistor NAT₁, du fait que sa grille est court circuitée à son drain, se comporte comme une diode : il sert à augmenter la tension du point A dès qu'un courant passe dans le transistor N₂ et dans le transistor NAT₁. La tension au point C est alors égale à la tension de seuil de conduction V_{T} du transistor N₂ (V_{TN2}) additionnée à la tension de seuil de conduction du transistor NAT₁ (V_{TNAT1}), c'est-à-dire 1,2 volts..
En effet, si la tension en C monte, les transistors N₂ et NAT₁ ont tendance à davantage conduire et font baisser la tension sur le point A. La tension C décroît alors naturellement, par le fait que les transistors N₁ et NAT₂ deviennent alors moins conducteurs. Par contre, si la tension en C baisse, ces deux transistors tendent à moins conduire et le phénomène inverse se produit. Ainsi les transistors N₁ et NAT₂ chargent la ligne de bits jusqu'à ce que la tension C ait atteint cette valeur.

Au moment de la lecture, la ligne de bits à lire peut être considérée ou non comme une résistance du point C à la masse, selon l'état de programmation de la cellule du point mémoire à lire dans cette ligne de bits. Lorsqu'il y a une liaison à la masse la tension au point C chute brutalement et le transistor NAT₂ doit laisser passer beaucoup de courant. Comme la commande du transistor NAT₂ n'a pas varié, puisque la tension du point A reste au même potentiel pendant la lecture, il en résulte que la tension d'un point B intermédiaire entre le transistor P₂ et le transistor NAT₂ remonte brutalement. Par contre, si au moment de la lecture on n'a pas détecté de "court circuit", la tension au point B reste à sa valeur initiale basse. Un montage inverseur de sortie P₄-N₄ connecté à ce point B, bascule, ou respectivement, ne bascule pas, en fonction de cette lecture. La sortie S délivre respectivement un signal haut (V_{cc}) ou un signal bas (Vₛₛ).

L'essentiel de la lenteur de la charge des lignes de bits provient du circuit de contre réaction NAT₂-N₂-NAT₁. Compte tenu de la technologie mise en oeuvre à ce jour, le temps de montée de la tension au point C jusqu'à la valeur de 1.2 volts est de l'ordre de 50 ns, dépendant du nombre de cellules par ligne de bits. Cette durée est bien trop longue.

On remarque par ailleurs que chaque ligne de bits, ou plutôt que chaque groupe, I à J, de lignes de bits doit être connecté à un détecteur de courant spécifique. Dans un montage particulier chaque ligne de bits est reliée à 512 points mémoires. Dans cet exemple, où la lecture est en huit bits, on réalise huit groupes de lignes de bits et dans chaque groupe de lignes de bits on peut avoir 64 lignes de bits (I = 1 ; J = 64). Dans chaque groupe de lignes de bits on a ainsi 64 bits de même poids correspondant à 64 mots différents. Il y a donc pour chaque groupe de lignes de bits un détecteur tel que le détecteur D. Ce montage nécessite une bonne maîtrise de fabrication puisque les lignes de bits dans chaque groupe sont chargées par des circuits de charge différents. Si, dans ces conditions, il y a une disparité de caractéristiques des transistors NAT₂, NAT₁ ou N₂, on pourra en plus être conduit à des abérrations de lecture.

Par ailleurs, GB-A-2070372 décrit une mémoire dont les lignes de bits sont préchargées jusqu'à ce que la tension sur les lignes de bits soit suffisamment élevée pour faire basculer un inverseur qui va ainsi commander l'arrêt de la précharge. La valeur de la tension de précharge des lignes de bits est dans ce cas imposée par le seuil de basculement de l'inverseur.

L'invention a pour objet de remédier à ces inconvénients en proposant un circuit de pré-charge des lignes de bits qui soit indépendant du détecteur lui-même et qui soit beaucoup plus puissant. Par ailleurs pour éviter les disparités de fabrication ainsi que pour limiter l'encombrement d'implantation dû à un circuit supplémentaire plus puissant de pré-charge, on a prévu de court circuiter toutes les lignes de bits à pré-charger, ensemble, au moment de la pré-charge. De ce fait on obtient à la fois une pré-charge rapide, identique pour toutes les lignes et sans un notable encombrement supplémentaire.

L'invention a donc pour objet une mémoire du type dont les points mémoires comportent un transistor à grille flottante, comportant des lignes de bits pour accéder à ces points mémoires, et des moyens pour pré-charger ces lignes de bits avant de lire des états électriques stockés dans ces points mémoires, caractérisée en ce qu'elle comporte un amplificateur différentiel recevant un signal de référence de tension de pré-charge à comparer à une tension de pré-charge effective d'un circuit ayant le comportement électrique d'une ligne de bits lors de la précharge, cet amplificateur différentiel délivrant un signal de commande de charge, et un transistor de puissance commandé par ce signal de commande pour précharger chacune des lignes de bits et le circuit ayant le comportement électrique d'une ligne de bits lors de la précharge, jusqu'à ce que la tension de précharge effective du circuit ayant le comportement électrique d'une ligne de bits lors de la précharge atteigne la valeur du signal de référence de tension de précharge.

L'invention sera mieux comprise à la lecture de la description qui suit et à l'examen des figures qui l'accompagnent. Celles-ci ne sont données qu'à titre indicatif et nullement limitatif de l'invention. Les figures montrent :
- figure 1 : la représentation schématique déjà évoquée d'une mémoire selon l'invention ;
- figures 2a à 2f : des diagrammes temporels de signaux mis en oeuvre dans l'invention.

La figure 1 montre une mémoire du type dont les points mémoires comportent un transistor TF à grille flottante. De tels transistors à grille flottante sont essentiellement simulés ici par des circuits RC ayant le même comportement que les lignes de bits au moment de leur pré-charge ainsi qu'au moment de leur lecture. En effet, du fait de leurs technologies spécifiques, les mémoires de type EEPROM comportent des réseaux de connexions constituant entre elles des capacités et dont la résistivité est telle qu'elle concourre à constituer un tel circuit RC. La mémoire comporte des lignes de bits telles que les lignes 1, 2 etc qui permettent d'accéder aux points mémoire. Elle comportent également un circuit P pour pré-charger les lignes de bits avant de lire les états électriques stockés dans ces points mémoire.

Selon une caractéristique importante de l'invention le circuit de pré-charge P comporte un amplificateur différentiel 3. Cet amplificateur différentiel reçoit d'une part un signal de référence de tension BLREF qui doit être comparé à un signal PRE de pré-charge effective de la ligne de bits. Cet amplificateur différentiel délivre un signal PRECHBL de commande de pré-charge de la ligne de bits. Ce signal de commande de pré-charge de la ligne de bits est appliqué en commande à un transistor de puissance 4 qui est connecté au point C à la ligne de bits pour la pré-charger. Par son autre borne le transistor 4 est relié à l'alimentation Vcc du circuit.

La structure du circuit P est la suivante. Deux transistors de type p enrichis, respectivement 5 et 6, sont montés en cascade avec deux transistors de type n natifs, respectivement 7 et 8, reliés ensemble par leurs sources respectivement 9 et 10. Le point commun des sources 9 et 10 est par ailleurs relié à la masse par un transistor 11 de type n. Les transistors natifs 7 et 8 forment l'étage différentiel. Ils reçoivent sur leur grille respectivement les signaux BLREF et PRE. Les deux grilles des deux transistors p 5 et 6 sont reliées ensemble et sont reliées en même temps au drain du transistor 5. Les transistors 5 et 6 forment un miroir de courant pour imposer des courants proportionnels dans les deux branches de l'amplificateur 3.

Au début de la pré-charge, comme on le verra plus loin, la tension disponible sur la ligne de bits, au point C, est nulle. En conséquence le signal de pré-charge de la ligne de bits PRE est nul. Lorsqu'on veut pré-charger on envoie un signal positif AM sur la grille de commande du transistor 11. Ce faisant les sources 9 et 10 des transistors natifs 7 et 8 peuvent être considérées comme reliées à la masse. L'amplificateur différentiel est alors mis en service. Au moment de la connexion à la masse des sources 9 et 10, les transistors 5 et 7 se mettent à conduire. En conséquence le transistor 6 se met à conduire également. Cependant, comme le signal de pré-charge effectif PRE appliqué sur la grille de commande du transistor natif 8 est alors nul, la tension drain source du transistor 8 est grande. En conséquence le drain du transistor 6 est porté au potentiel d'alimentation : V_{cc}. Le potentiel du drain du transistor 6 ainsi que l'ordre AM de validation du fonctionnement de l'amplificateur différentiel sont appliqués sur les entrées d'une porte NON-ET 12 qui délivre alors un état logique zéro. Cet état logique zéro est introduit sur l'entrée d'un inverseur 13 qui délivre un signal de commande de pré-charge des lignes de bits PRECHBL maintenant à l'état 1. Cet ordre à l'état 1 rend conducteur le transistor 4 de charge de la ligne de bits.

Le signal de charge de la ligne de bits est par ailleurs prélevé au point C et est conduit, par l'intérmédiaire d'un circuit de simulation R′C′, sur la grille de commande du transistor natif 8 en tant que signal PRE. Le circuit R′C′ est un circuit de simulation de la charge d'une ligne de bits. Ce circuit R′C′ existe réellement : son indication n'est pas symbolique ici. Le but de ce circuit est de connaître la tension effective de pré-charge de la ligne de bits, au bout de la ligne de bits, et non pas à son entrée. Le point milieu du circuit R′C′ délivre donc un signal PRE de pré-charge effective de la ligne de bits.

On aurait pu remplacer le circuit R′C′ par une ligne de bits réelle, supplémentaire, par exemple du type de celle utilisée en réparation. Néammoins le choix d'un circuit R′C′ est préféré parce qu'il occupe moins de place. Par ailleurs, comme on le verra également plus loin, d'une manière préférée, on pré-charge plusieurs lignes de bits en même temps, et il faudrait donc créer une simulation de la pré-charge de plusieurs lignes de bits en même temps, ce qui ne peut pas être équivalent à la pré-charge d'une seule ligne de bits.

Dès que le signal de pré-charge effective de la ligne de bits a atteint le niveau imposé par le signal de référence BLREF, la tension drain source du transistor 8 se met à décroître, l'amplificateur différentiel 3 bascule, et le signal de commande de pré-charge de ligne de bits PRECHBL bascule : il repasse à l'état zéro. Ce faisant, le transistor 4 se bloque. A ce moment la pré-charge est terminée et la ligne de bits est disponible pour la lecture proprement dite. Par ailleurs un transistor 14, placé en série entre le point C et le circuit R′C′, et également commandé par le signal de commande de pré-charge PRECHBL, se bloque lui aussi. Il découple alors l'amplificateur différentiel du circuit de lecture de la mémoire. Ce faisant on évite de fausser la mesure de la chute de tension au point C du fait de la présence des capacités de l'amplificateur différentiel 3 (et de celle du circuit R′C′) qui pourrait retarder le basculement de l'inverseur P₄ N₄.

Comme on l'a expliqué précédemment, on profite de la présence du signal de commande de pré-charge de ligne de bits pour court-circuiter ensemble toutes les lignes de bits. On effectue ce court-circuit au moyen de transistors de type n tels que 15, 16 et 17 interposés en parallèle entre tous les groupes de lignes de bits, à l'endroit de leur connexion aux détecteurs D correspondant. Le signal de commande de pré-charge des lignes de bits PRECHBL est appliqué sur les grilles de commande de ces transistors 15 à 17. Il les rend conducteurs au moment de cette pré-charge. Dès que la pré-charge est terminée les transistors 14 à 17 sont bloqués : les lignes de bits récupèrent leur indépendance. On remarque que le fait de court circuiter ensemble au moment de la pré-charge toutes les lignes de bits a pour second avantage d'assurer que toutes les lignes de bits seront pré-chargées à une même valeur, et que cette valeur est ainsi indépendante des disparités des caractéristiques des transistors de pré-charge des détecteurs eux-mêmes.

Le détecteur D lui-même est conservé dans sa définition ancienne : ceci a pour avantage supplémentaire que la mise en oeuvre du perfectionnement de l'invention ne complique pas la conception des circuits de lecture des circuits intégrés.

Pour que l'amplificateur différentiel 3 soit très rapide, les transistors de type p 5 et 6 sont de préférence de gros transistors. Par ailleurs les transistors de comparaison 7 et 8 sont de préférence des transistors natifs. En effet, la zone de bon fonctionnement d'un amplificateur différentiel de type n est comprise entre 2V_{T} et V_{cc}. Or, la tension de seuil V_{T} d'un transistor de type n normal (c'est-à-dire enrichi) est de l'ordre de 1.5 volt. En conséquence un amplificateur différentiel de ce type fonctionnerait bien lorsque les tensions à comparer, PRE et BLREF seraient supérieures à 3 volts et inférieures à V_{cc}. Or ce n'est pas le cas puisque la tension de pré-charge à obtenir est de 1.2 volts. En retenant des transistors natifs, dont la tension de seuil de conduction V_{T} est de l'ordre de 0.2 volts, on aboutit facilement dans une bonne plage de fonctionnement.

L'idéal aurait été l'utilisation d'un comparateur différentiel de type p. Mais cette solution ne peut pas être retenue, même dans une technologie de type CMOS, pour des raisons de taille qu'implique une telle structure dans le circuit intégré. En effet les transistors de type p nécessitent la présence de caissons supplémentaires qui sont trop encombrants.

La présence de l'amplificateur différentiel permet de pré-charger les lignes de bits comme si on voulait atteindre une valeur de pré-charge de V_{cc} au moyen du transistor 4. La constante de temps de pré-charge des lignes de bits n'est pas changée. Cependant, compte tenu que l'objectif de tension que l'on se fixe est supérieur, on atteint plus rapidement le seuil de 1.2 volt que si on avait visé justement l'obtention de ce seuil. L'amplificateur différentiel permet de couper la pré-charge dès que cette tension a été atteinte. De plus, avec l'amplificateur différentiel 3, la contre-réaction NAT₂, NAT₁, N₂ ne devient plus prépondérante.

Le fonctionnement du circuit total est le suivant : avant de commencer un cycle de lecture il est maintenant nécessaire de décharger toutes les lignes de bits avant de charger les bonnes lignes de bits. Dans ce but, par un ordre de remise à zéro RAZ préalable, on court-circuite à la masse, avant et après un décodeur d'accès aux lignes de bits, toutes les lignes de bits.

L'ordre RAZ est appliqué sur des grilles de transistors de type n tels que 18 à 25. Ceux-ci sont placés en parallèle entre ces lignes de bits et la masse du circuit. En agissant ainsi, on est sur de disposer du potentiel de masse V_{SS} de part et d'autre du décodeur. Cette opération de remise à zéro dure de l'ordre de 20 ns. Cette remise à zéro ne provoque cependant pas de perte de temps car elle peut être effectuée pendant l'opération de décodage elle-même.

L'ordre de remise à zéro est par ailleurs appliqué également sur un transistor 26 de type n branché en parallèle entre l'entrée de la grille de commande du transistor natif 8 et la masse. Au moment de la remise à zéro on s'assure ainsi que le signal PRE de pré-charge effective est lui-même également à zéro.

La remise à zéro préalable des lignes de bits est maintenant nécessaire parce qu'une ligne de bits peut être restée charge depuis une précédente écriture, auquel cas sa tension peut être restée supérieure à 1,2 volts. Sans remise à zéro, l'amplificateur différentiel serait neutralisé puisque le signal PRE serait dès le début plus grand que BLREF. Dans ce cas, du fait qu'avec le dispositif de l'invention, on effectue la précharge plus rapidement (10 ns au lieu de 50 ns) et comme alors on n'attend plus la stabilisation à 1,2 volts fournie par le détecteur D, on risquerait, sans cette remise à zéro préalable, d'effectuer des lectures incorrectes.

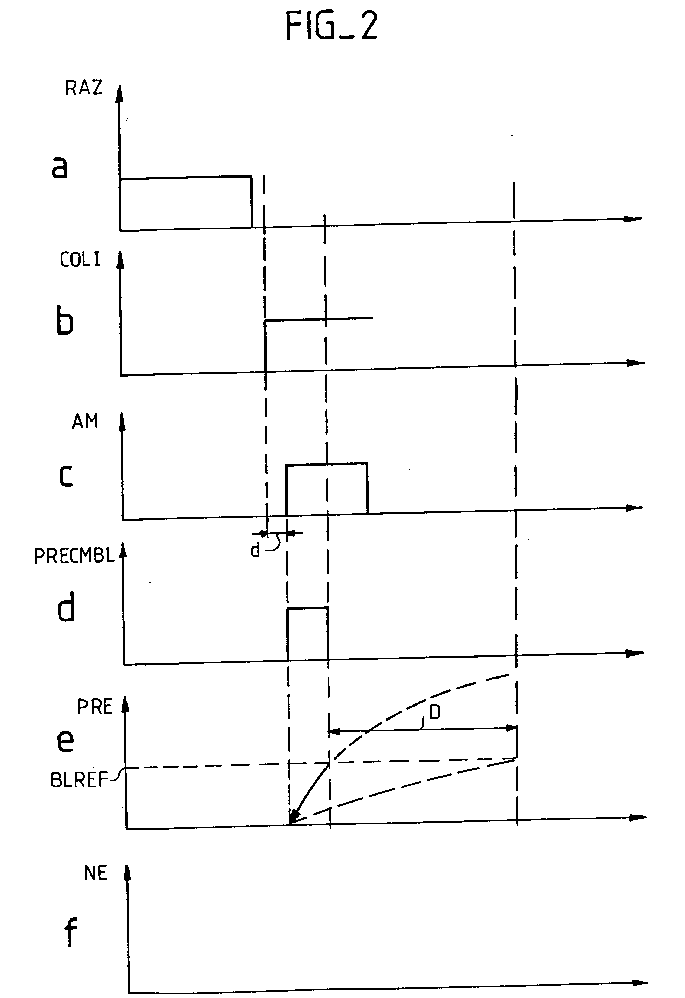

A l'aide de la figure 2 on peut comprendre l'évolution des signaux. Une fois que la remise à zéro est acquise, on sélectionne la véritable ligne de bits que l'on veut pré-charger. Par exemple par un ordre COL I on sélectionne une parmi les 64 lignes de bits connectées à chacun des huit groupes de lignes de bits. Ainsi dans le premier groupe on veut pré-charger la ligne de bits 1 et dans le dernier groupe on veut pré-charger la ligne de bits 27. Avec le circuit de l'invention la pré-charge est maintenant plus rapide, elle est de l'ordre de 10 ns. Aussi il est nécessaire d'attendre que la sélection des bonnes lignes de bits soit effectuée. Ceci signifie que l'ordre AM de validation de l'amplificateur différentiel 3 doit être lancé avec un certain retard d par rapport au début de la sélection des lignes de bits. Auparavant compte tenu du temps de montée à 1.2 volts relativement lent des circuits de pré-charge, ce retard n'était pas critique : les deux ordres pouvaient être simultanés. Maintenant il est necessaire que l'ordre de validation AM se présente au bout d'une durée de l'ordre de 5 ns après le début de la sélection. La pré-charge commandée de la ligne de bits est alors immédiate. L'ordre de pré-charge de ligne de bits PRECHBL dure jusqu'à ce que (figure 2e) le signal PRE ait atteint la valeur BLREF.

D'une manière préférée on peut même accélérer la pré-charge du circuit de détection lui-même. En effet la stabilisation de la tension au point A à la valeur V_{TN} + V_{TNAT} est toujours aussi lente. Dans ce but, on interpose entre la source du transistor N₁ du détecteur D et la grille de ce transistor un transistor de court-circuit N_{cc}. Le transistor de court circuit est commandé par le signal de pré-charge de ligne de bits PRECHBL. Dès que cette pré-charge est en cours on impose alors au potentiel du point A de se porter au potentiel de pré-charge de la ligne de bits. Dès que la pré-charge est terminée le transistor Ncc de court-circuit se bloque et le point A redevient électriquement indépendant par rapport à la tension de pré-charge. La figure 2e montre également le gain de temps D obtenu pendant un cycle de lecture avec le procédé de l'invention. Dans un cycle total de lecture de 200 ns les opérations de lecture proprement dites, de type classique, peuvent être débutées avec l'invention 40 ns plus tôt que précédemment.

Un signal NE, ou son complémentaire EN, est appliqué sur les grilles de commande de transistors respectivement N₃ et P₃. Le transistor N₃ est branché entre le point A et la masse ; le transistor P₃ est branché contre le point B et l'alimentation. Ces signaux servent à désactiver le détecteur D. Ils sont de type connu, ils permettent à l'utilisateur de gérer le détecteur.

## Revendications

1. Mémoire en circuit intégré du type dont les points mémoires comportent un transistor (TF) à grille flottante, comportant des lignes (1) de bits pour accéder à ces points mémoires, et des moyens (P) pour précharger ces lignes de bits avant de lire des états électriques stockés dans ces points mémoires, caractérisée en ce qu'elle comporte un amplificateur (3) différentiel recevant un signal de référence de tension (BLREF) de pré-charge à comparer à une tension de pré-charge (PRE) effective d'un circuit (R′C′) ayant le comportement électrique d'une ligne de bits lors de la précharge, cet amplificateur différentiel délivrant un signal de commande de charge (PRECHBL), et un transistor (4) de puissance commandé par ce signal de commande pour précharger chacune des lignes de bits et le circuit ayant le comportement électrique d'une ligne de bits lors de la précharge, jusqu'à ce que la tension de précharge (PRE) effective du circuit (R′C′) ayant le comportement électrique d'une ligne de bits lors de la précharge atteigne la valeur du signal de référence de tension (BLREF) de précharge.

2. Mémoire selon la revendication 1, caractérisée en ce que le circuit ayant le comportement électrique d'une ligne de bits lors de la précharge comporte un circuit RC (R′ C′).

3. Mémoire selon la revendication 1 ou la revendication 2, caractérisée en ce qu'elle comporte un circuit (15-17) pour relier entre elles les lignes de bits au moment de la pré-charge.

4. Mémoire selon l'une quelconque des revendications 1 à 3, caractérisée en ce que l'amplificateur différentiel comporte, pour comparer, deux transistors natifs (7, 8) afin de ne pas introduire d'erreur dans la comparaison de la référence de tension à la tension de pré-charge effective.

5. Mémoire selon l'une quelconque des revendications à 4, caractérisée en ce qu'elle comporte un circuit (14) pour découpler l'amplificateur différentiel au moment de la lecture des états électriques, pour éviter le maintien en tension de la ligne de bits du fait de la présence des capacités parasites de cet amplificateur différentiel.

6. Mémoire selon l'une quelconque des revendications 1 à 5, caractérisée en ce qu'elle comporte un circuit de lecture (D) des états électriques, ce circuit de lecture comportant un pont diviseur à transistors (P₁, N₂, NA₁) pour fixer en son point milieu (A) la tension de pré-charge à une valeur donnée et un transistor (Ncc) pour relier ce point milieu directement à la ligne de bit pendant la pré-charge.

## Patentansprüche

1. Speicher in integrierter Schaltung von dem Typ, bei dem die Speicherplätze einen Transistor (TF) mit offenem Gitter umfassen, umfassend Bitleitungen (1) zum Zugreifen auf die Speicherplätze und Mittel (P) zum Vorladen der Bitleitungen, bevor die in den Speicherplätzen gespeicherten elektrischen Zustände gelesen werden, dadurch **gekennzeichnet,** daß er einen Differentialverstärker (3), der ein Vorlade-Spannungsreferenzsignal (BLREF) zum Vergleichen mit einer effektiven Vorladespannung (PRE) an einer Schaltung (R′C′) empfängt, die das elektrische Verhalten einer Bitleitung zur Zeit der Vorladung, wobei der Differentialverstärker ein Ladesteuersignal (PRECHBL) ausgibt, und einen Leistungstransistor (4) umfaßt, der durch das Steuersignal gesteuert ist, um jede der Bitleitungen vorzuladen, und wobei die Schaltung das elektrische Verhalten einer Bitleitung zur Zeit der Vorladung umfaßt, bis die effektive Vorladespannung (PRE) der Schaltung (R′C′), die das elektrische Verhalten einer Bitleitung zur Zeit der Vorladung aufweist, den Wert des Vorlade-Spannungsreferenzsignals (BLREF) erreicht.

2. Speicher nach Anspruch 1, dadurch **gekennzeichnet,** daß die Schaltung, die das elektrische Verhalten einer Bitleitung zur Zeit der Vorladung umfaßt, eine Schaltung RC (R′C′) umfaßt.

3. Speicher nach Anspruch 1 oder Anspruch 2, dadurch **gekennzeichnet,** daß er eine Schaltung (15-17) umfaßt, um untereinander die Bitleitungen im Augenblick der Vorladung zu verbinden.

4. Speicher nach einem beliebigen der Ansprüche 1 bis 3, dadurch **gekennzeichnet,** daß der Differentialverstärker zum Vergleichen zwei in ihm enthaltene Transistoren (7, 8) umfaßt, um in den Vergleich der Referenzspannung mit der effektiven Vorladespannung keinen Fehler einzuführen.

5. Speicher nach einem beliebigen der Ansprüche 1 bis 4, dadurch **gekennzeichnet,** daß er eine Schaltung (14) umfaßt, um den Differentialverstärker im Augenblick des Lesens der elektrischen Zustände zu entkoppeln, um das In-der-Spannung-halten der Bitleitung infolge des Vorhandenseins der parasitären Kapazitäten dieses Differentialverstärkers zu vermeiden.

6. Speicher nach einem beliebigen der Ansprüche 1 bis 5, dadurch **gekennzeichnet,** daß er eine Schaltung zum Lesen (D) der elektrischen Zustände, wobei diese Schaltung eine Teilerbrücke mit Transistoren (P₁, N₂, NA₁) umfaßt, um im Mittenpunkt (A) die Vorladespannung auf einen gegebenen Wert festzulegen, und einen Transistor (Ncc) umfaßt, um den Mittenpunkt direkt mit der Bitleitung während der Vorladung zu verbinden.

## Claims

1. Integrated-circuit memory of the type in which the memory locations include a floating-gate transistor (TF), including bit lines (1) for accessing these memory locations, and means (P) for precharging these bit lines before reading electrical states stored in these memory locations, characterised in that it includes a differential amplifier (3) receiving a precharge voltage reference signal (BLREF) to be compared with an actual precharge voltage (PRE) of a circuit (R′C′) having the electrical behaviour of a bit line at the time of precharging, this differential amplifier delivering a charge control signal (PRECHBL), and a power transistor (4) controlled by this control signal in order to precharge each of the bit lines, and the circuit having the electrical behaviour of a bit line at the time of precharging, until the actual precharge voltage (PRE) of the circuit (R′C′) having the electrical behaviour of a bit line at the time of precharging reaches the value of the precharge voltage reference signal (BLREF).

2. Memory according to Claim 1, characterised in that the circuit having the electrical behaviour of a bit line at the time of precharging includes an RC circuit (R′C′).

3. Memory according to Claim 1 or Claim 2, characterised in that it includes a circuit (15-17) for connecting the bit lines together at the moment of precharging.

4. Memory according to any one of Claims 1 to 3, characterised in that the differential amplifier includes, for comparing, two native transistors (7, 8) so as not to introduce any error into the comparison of the reference voltage with the actual precharge voltage.

5. Memory according to any one of Claims 1 to 4, characterised in that it includes a circuit (14) for decoupling the differential amplifier at the time of reading the electrical states, to avoid keeping the bit line energised because of the presence of the stray capacitances of this differential amplifier.

6. Memory according to any one of Claims 1 to 5, characterised in that it includes a circuit (D) for reading the electrical states, this read circuit including a transistor divider network (P₁, N₂, NA₁) for fixing, at its mid-point (A), the precharge voltage at a given value and a transistor (Ncc) for connecting this mid-point directly to the bit line during the precharging.
